(19) Europäisches Patentamt
European Patent Office
Office européen des brevets

(11) Publication number: 0 379 200 A2

(12) **EUROPEAN PATENT APPLICATION**

(21) Application number: 90101025.6

(51) Int. Cl.[5]: G03F 7/031, G03F 7/029

(22) Date of filing: 18.01.90

(30) Priority: 19.01.89 JP 10736/89
28.11.89 JP 308395/89

(43) Date of publication of application:
25.07.90 Bulletin 90/30

(84) Designated Contracting States:
DE FR GB

(71) Applicant: MITSUBISHI KASEI CORPORATION
5-2, Marunouchi 2-chome Chiyoda-ku
Tokyo 100(JP)

(72) Inventor: Nagasaka, Hideki
3-12-3, Tsukimino
Yamato-shi, Kanagawa-ken(JP)
Inventor: Ohta, Katsuko
1-39-10, Fujigaoka, Midori-ku
Yokohama-shi, Kanagawa-ken(JP)

(74) Representative: Wächtershäuser, Günter, Dr.
Tal 29
D-8000 München 2(DE)

# (54) Photopolymerizable composition.

(57) A photopolymerizable composition comprising an addition polymerizable ethylenically unsaturated compound and a photopolymerization initiator system, wherein the photopolymerization initiator system comprises:

(a) a squarylium dye, and

(b) a triazine compound having at least one halogenated methyl group.

EP 0 379 200 A2

# PHOTOPOLYMERIZABLE COMPOSITION

The present invention relates to a photopolymerizable composition. Particularly, it relates to a photopolymerizable composition showing a high sensitivity to light rays in a long wavelength range.

Heretofore, a number of image forming methods have been known in which a photopolymerizing system is utilized. For example, there are a method wherein a photopolymerizable composition comprising an addition polymerizable compound containing an ethylenic double bond and a photopolymerization initiator, and optionally as an additional component an organic polymer binder, is prepared, this photopolymerizable composition is coated on a substrate to obtain a photosensitive material provided with a layer of the photopolymerizable composition, exposure of a desired image is conducted so that the exposed portion is polymerized and cured, and the unexposed portion is then dissolved and removed to form a cured relief image; a method wherein a change in the bonding strength is created by the radiation, and then the substrate is peeled off to form an image; and a method wherein an image is formed by utilizing a change in the adhesion of a tonner caused by radiation to a layer of a photopolymerizable composition. As the photopolymerization initiator of the photopolymerizable composition used in these methods, benzoin, benzoin alkyl ether, benzil ketal, benzophenone, anthraquinone, benzil or Michler's ketone has been employed. These photopolymerization initiators have an ability to initiate photopolymerization with light rays of short wavelength in the ultraviolet light range of at most 400 nm.

In recent years, with the progress of image-forming techniques, there has been a strong demand for photopolymers highly sensitive to light rays in the visible light range. For example, a plate making system employing an oscillation beam of 488 nm of an argon ion laser is considered to be one of the most prospective techniques. Accordingly, a number of photopolymerization initiator systems having the sensitivity range extended to about 500 nm, have been proposed. Further, recently, a study of a photoinitiator system corresponding to light rays of a long wavelength exceeding 600 nm, has been active. One of the applied techniques thereof is a laser plate making by means of a He-Ne laser or a semiconductor laser, and another application is a technique for reproducing a full color image by means of a photopolymerization system.

With respect to the latter, there has been a disclosure as old as Japanese Examined Patent Publication No. 41346/1971. According to the disclosure, three-layers having dispersed, respectively, in gelatin layers, small droplet-like polymerizable compositions containing photopolymerizable initiators and color couplers corresponding to blue, green and red lights, respectively, were coated to form a photosensitive layer. Then, color image light rays are irradiated, followed by treatment with color-developing solutions, whereby non-cured portions are color-developed to obtain a full color image. Further, an applied technique wherein this concept is combined with a technique of a pressure sensitive color-development by means of microcapsules, has also been proposed. For example, such a disclosure is found in Japanese Unexamined Patent Publication No. 143044/1987. According to the publication, a photopolymerizable composition comprising photopolymerization initiators sensitive to the respective three color light rays and the respective leuco dyes, is filled in microcapsules and coated on a sheet. This coated sheet is exposed to color image light rays, and the capsules at the non-cured portions are pressed and broken on a color-developing sheet, and transferred to develop yellow, magenta and cyan colors to obtain a full color image.

In the above-mentioned laser plate making by means of a long wavelength laser or in the technique for reproducing a full color image by means of a panchrocolor sensitive material, it is technically most desired to improve the sensitivity of the photosensitive material to light rays in a range exceeding about 600 nm.

It is generally well known that the ability of a photopolymerization initiator system for generating active radicals sharply decreases against light rays of a wavelength exceeding 500 nm, particularly 600 nm. This is considered to be attributable basically to the fact that when the energy under excitation by lights decreases, the ability to cleave the molecules decreases or disappears, whereby active radicals will be hardly generated. Heretofore, some photopolymerizable initiators corresponding to such long wavelength lights have been proposed, but they are inadequate in the sensitivity.

For example, some of the present inventors have previously reported that a photopolymerization initiator system consisting of a combination of a certain specific cyanine dye and a triazine derivative, shows a high sensitivity in a visible range of from 400 to 500 nm (Japanese Unexamined Patent Publication No. 29803/1983). However, it has been considered difficult to obtain a good sensitivity in a range exceeding 600 nm and in a range up to the near infrared range, in view of the energy under excitation by lights.

Under these circumstances, the present inventors have conducted extensive researches to overcome such difficulties, and as a result, have found that a system composed of a combination of a squarylium dye and a certain specific s-triazine compound, can be a photopolymerization initiator system which is very

effective in the above-mentioned long wavelength range. The present invention has been accomplished on the basis of this discovery.

The present invention provides a photopolymerizable composition comprising an addition polymerizable ethylenically unsaturated compound and a photopolymerization initiator system, wherein the photopolymerization initiator system comprises:

(a) a squarylium dye, and

(b) a triazine compound having at least one halogenated methyl group.

Now, the present invention will be described in detail with reference to the preferred embodiments.

The addition polymerizable compound having at least one ethylenically unsaturated double bond (hereinafter referred to simply as "ethylenic compound") contained as a first essential component in the photopolymerizable composition of the present invention is a compound having an ethylenically unsaturated double bond, which is capable of undergoing addition polymerization and being cured by the action of the photopolymerization initiator system as a second essential component, when the photopolymerizable composition is irradiated with active light rays. For example, it may be a monomer having such a double bond or a polymer having an ethylenically unsaturated double bond in its side chain or main chain. In the present invention, the monomer is meant for a substance as opposed to a so-called polymer substance and includes dimers, trimers and oligomers in addition to monomers in a narrow sense.

The monomer having an ethylenically unsaturated double bond includes, for example, an unsaturated carboxylic acid, an ester thereof with a monohydroxy compound, an ester of an unsaturated carboxylic acid with an aliphatic polyhydroxy compound, an ester of an unsaturated carboxylic acid with an aromatic polyhydroxy compound and an ester obtained by the esterification reaction of an unsaturated carboxylic acid and a polybasic carboxylic acid with a polyhydroxy compound such as the above-mentioned aliphatic polyhydroxy compound or aromatic polyhydroxy compound.

The above-mentioned ester of an unsaturated carboxylic acid with an aliphatic polyhydroxy compound is not particularly limited and includes, as specific examples, acrylic acid esters such as ethylene glycol diacrylate, triethylene glycol diacrylate, trimethylolpropane triacrylate, trimethylolethane triacrylate, pentaerythritol diacrylate, pentaerythritol triacrylate, pentaerythritol tetracrylate, dipentaerythritol tetracrylate, dipentaerythritol pentacrylate, dipentaerythritol hexacrylate and glycerol acrylate; methacrylic acid esters corresponding to the above examples wherein "acrylate" is changed to "methacrylate"; itaconic acid esters corresponding to the above examples wherein "acrylate" is likewise changed to "itaconate"; crotonic acid esters corresponding to the above examples wherein "acrylate" is likewise changed to "crotonate"; and maleic acid esters corresponding to the above examples wherein "acrylate" is likewise changed to "maleate".

The ester of an unsaturated carboxylic acid with an aromatic polyhydroxy compound includes, for example, hydroquinone diacrylate, hydroquinone dimethacrylate, resorcinol diacrylate, resorcinol dimethacrylate and pyrogallol triacrylate.

The ester obtained by the esterification reaction of an unsaturated carboxylic acid and a polybasic carboxylic acid with a polyhydroxy compound may not necessarily be a single compound. Typical specific examples include a condensation product of acrylic acid, phthalic acid and ethylene glycol, a condensation product of acrylic acid, maleic acid and diethylene glycol, a condensation product of methacrylic acid, terephthalic acid and pentaerythritol and a condensation product of acrylic acid, adipic acid, butane diol and glycerol.

Other ethylenic compounds which may be used in the present invention include, for example, acrylamides such as ethylene bisacrylamide; allyl esters such as diallyl phthalate; and vinyl group-containing compounds such as divinyl phthalate.

The polymer having an ethylenically unsaturated double bond on the main chain includes, for example, a polyester obtained by the polycondensation reaction of an unsaturated dibasic carboxylic acid with a dihydroxy compound, and a polyamide obtained by the polycondensation reaction of an unsaturated dibasic carboxylic acid with a diamine. The polymer having an ethylenically unsaturated double bond at the side chain may be a condensation polymer of a dibasic carboxylic acid having an unsaturated bond at the side chain such as itaconic acid, propylidenesuccinic acid or ethylidenemalonic acid with a dihydroxy or diamine compound. Further, a polymer having a functional group having a reactivity such as a hydroxyl group or a halogenated methyl group in the side chain, such as a polymer obtained by a polymer reaction of e.g. polyvinyl alcohol, poly(2-hydroxyethyl methacrylate) or polyepichlorohydrin with an unsaturated carboxylic acid such as acrylic acid, methacrylic acid or crotonic acid, may also be suitable for use.

Among the above-mentioned ethylenic compounds, monomers of acrylic acid esters or methacrylic acid esters are particularly suitable for use.

Now, the photopolymerization initiator system as a second essential component of the photopolymerizable composition of the present invention will be described.

The photopolymerization initiator system of the present invention is a combination of two components. The first component (a) is a squarylium dye. A preferred squarylium dye is represented by the following formula I:

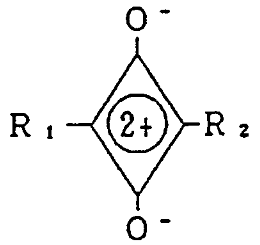

(I)

wherein each of $R_1$ and $R_2$ is a substituted or unsubstituted aminophenyl group or Y=CH- wherein Y= is a nitrogen-containing heterocyclic group.

Each of $R_1$ and $R_2$ is in the squarylium dye of the formula I generally includes an aminophenyl group, an (indolin-2-ylidene)methyl group, a (benzothiazolylidene)methyl group, a (naphthothiazol-2(3H)-ylidene)-methyl group, a (quinolinylidene)methyl group, a (benzoselenazolylidene)methyl group and a pyrrolyl group. These groups preferably have an alkyl group or aryl group on their nitrogen atoms, or they may have a substituent such as an alkyl group or an aryl group at other positions. Specific examples for each of $R_1$ and $R_2$ include, for example, 4-N-n-hexylaminophenyl, 4-N,N-di-n-butylaminophenyl, 4-N,N-di-n-octylaminophenyl, 4-N-methyl-N-n-dedecylaminophenyl, 4-N,N-diethylamino-2-methylphenyl, 4-N,N-di-n-hexylamino-2-methoxyphenyl, 4-N-ethyl-N-benzylaminophenyl, 4-N,N-dibenzylaminophenyl, 9-julolidyl, (1,3,3-trimethylindolin-2-ylidene)methyl, (1-phenyl-3,3-dimethylindolin-2-ylidene)methyl, (1-n-pentyl-3,3-dimethylindolin-2-ylidene)methyl, (1-n-octyl-3,3-dimethylindolin-2-ylidene)methyl, (3-ethyl-2(3H)-benzothiazolylidene)methyl, (3-n-heptyl-2(3H)-benzothiazolylidene)methyl, (3-ethylnaphtho[1,2-d]thiazol-2(3H)-ylidene)methyl, (3-ethylnaphtho[2,1-d]thiazol-2(3H)-ylidene)methyl, 3-n-octylnaphtho[2,1-d]thiazol-2(3H)-ylidene)methyl, (3-ethyl-6,7,8,9-tetrahydronaphtho[2,1-d]thiazol-2(3H)-ylidene)methyl, (1-n-octyl-2(1H)-quinolinylidene)methyl, (1-n-dodecyl-4(1H)quinolinylidene)methyl, (3-n-hexyl-2(3H)-benzoselenazolylidene)-methyl and 3,5-dimethyl-1H-pyrrol-2-yl.

Among them, a particularly preferred squarylium dye in the present invention has, as each of $R_1$ and $R_2$, an (indolin-2-ylidene)methyl group, a (benzothiazolylidene)methyl group, a (naphtho[1,2-d]thiazol-2(3H)-ylidene)methyl group or a (2(1H)-quinolinylidene)methyl group.

The squarylium dyes illustrated above, to be used in the present invention, can be prepared in a usual method, for example, by a method disclosed by H.E. Sprenger, Angew. Chem. internot Edit 6 553 (1967).

Now, the second component (b) constituting the photopolymerization initiator system of the present invention will be described.

The component (b) is a s-triazine derivative having at least one mono-, di- or tri-halogenated methyl group bonded to the s-triazine ring. It includes, for example, compounds disclosed by e.g. Wakabayashi et al, Bull. Chem. Soc. Japan, 42, 2924 (1969), in U.S. Patent 3,987,037, or by F.C. Schaefer et al, J. Org. Chem., 29, 1527 (1964). Specific examples of such compounds will be given below. The letters in the bracket [ ] are the reference symbols for the respective compounds, which will be referred to hereinafter. Such compounds include, for example, 2,4,6-tris(trichloromethyl)-s-triazine [b-1], 2-methyl-4,6-bis-(trichloromethyl)-s-triazine [b-2], 2-phenyl-4,6-bis(trichloromethyl)-s-triazine, 2-(p-chlorophenyl)-4,6-bis-(trichloromethyl)-s-triazine, 2-phenylthio-4,6-bis(trichloromethyl)-s-triazine [b-3], 2-benzylthio-4,6-bis-(trichloromethyl)-s-triazine [b-4], 2-(p-tolyl)-4,6-bis(trichloromethyl)-s-triazine [b-5], 2-(p-methoxyphenyl)-4,6-bis(trichloromethyl)-s-triazine, 2-n-propyl-4,6-bis(trichloromethyl)-s-triazine, 2-(α,α,β-trichloroethyl)-4,6-bis-(trichloromethyl)-s-triazine, 2-styryl-4,6-bis(trichloromethyl)-s-triazine, 2,4,6-tris(dichloromethyl)-s-triazine, 2,4,6-tris(monochloromethyl)-s-triazine, 2-(p-methoxystyryl)- 4,6-bis(trichloromethyl)-s-triazine, 2,4,6-tris-(tribromomethyl)-s-triazine [b-6], 2-methyl-4,6-bis(tribromomethyl)-s-triazine, 2,4,6-tris(dibromomethyl)-s-triazine or 2-methoxy-4,6-bis(tribromomethyl)-s-triazine. Among them, particularly preferred are s-triazines containing at least two trichloro or tribromo methyl groups, such as 2,4,6-tris(trichloromethyl)-s-triazine, 2-phenyl-4,6-bis(trichloromethyl)-s-triazine, 2-methyl-4,6-bis(trichloromethyl)-s-triazine, 2-phenylthio-4,6-bis-(trichloromethyl)-s-triazine and 2,4,6-tris(tribromomethyl)-s-triazine. These s-triazines can be prepared either by reacting the corresponding nitrile compounds with aluminum chloride in the presence of hydrogen chloride or via the corresponding imidates, in accordance with the above identified literatures.

The photopolymerization initiator of the present invention is capable of providing remarkable effects

only by the combination of the above-mentioned two components (a) and (b). The two components are used preferably in a weight ratio of (a) to (b) within a range of from 1:30 to 10:1, more preferably within a range of from 1:15 to 4:1. The photopolymerization initiator system contained in the photopolymerization composition of the present invention, i.e. the total amount of the components (a) and (b), is preferably within a range of from 0.1 to 30% by weight, more preferably from 0.5 to 20% by weight, relative to the above-mentioned ethylenic compound.

The photopolymerizable composition of the present invention may contain, in addition to the above described respective constituting components, other substances depending upon its particular purpose.

For example, when a film-forming ability or a viscosity controlling ability is required, an organic polymer substance may be added as a binder. For example, a homopolymer or copolymer of e.g. (meth)acrylic acid, an ester thereof, maleic acid, acrylonitrile, styrene, vinyl acetate or vinylidene chloride, as well as polyethylene oxide, polyvinylpyrrolidone, polyamide, polyurethane, polyethylene terephthalate isophthalate, acetyl cellulose or polyvinyl butyral, may be mentioned. Such a binder may be incorporated in an amount within a range of not more than 500% by weight, preferably not more than 200% by weight, relative to the above ethylenic compound.

Further, additives including a thermal polymerization preventing agent such as hydroquinone, p-methoxyphenol or 2,6-di-t-butyl-p-cresol; a coloring agent such as an organic or inorganic dyestuff or pigment; a plasticizer such as dioctyl phthalate, dodecyl phthalate, tricrezyl phosphate, dioctyl adipate or triethylene glycol dicaprylate and a sensitivity-improving agent such as a tertiary amine or a thiol, may be added.

When the composition of the present invention is applied to the technique for reproducing a color image, a colorant precursor such as a color-forming material used in a conventional color photographic film as disclosed in Japanese Examined Patent Publication No. 41346/1971 or a leuco colorant well known in the technical field of pressure sensitive colorants, may be incorporated. The leuco colorant includes, for example, a triarylmethane, bisarylmethane, a xanthene compound, a fluoran, thiazine compound and compounds having a lactone, lactum, sultone or spiropyran structure as a part of their structures.

Preferred amounts of the above-mentioned various additives are at most 2% by weight of the thermal polymerization preventing agent, at most 20% by weight of the coloring agent, at most 40% by weight of the plasticizer and at most 40% by weight of the colorant precursor, relative to the solid content of the photopolymerizable composition.

The type of a light sensitive material prepared by using the composition of the present invention, can suitably be selected depending upon the particular purpose.

For example, it is possible to select various types including a type wherein the composition is coated on e.g. a polymer sheet, a paper sheet or a metal sheet and dried, and if necessary, an overcoat layer may be provided as an upper layer to shield oxygen off, a type wherein a plurality of sensitive materials dispersed in different phase media in the form of small droplets, are coated in a plurality of layers, and a type wherein the composition is encapsulated in microcapsules and coated on a sheet.

There is no particular restriction as to the light source for radiation applicable to the composition of the present invention. A commonly employed light source containing visual light rays of at least 600 nm may suitably be used, such as a carbon arc, a high pressure mercury lamp, a xenone lamp, a metal halide lamp, a fluorescent lamp, a tungsten lamp, a halogen lamp, a helium-neon laser or a semiconductor laser.

Now, the present invention will be described in further detail with reference to Examples and Comparative Examples. However, it should be understood that the present invention is by no means restricted by these specific Examples.

In the Examples and Comparative Examples, the abbreviations for the component (a) represent the following structures. Among them, r-1 is a compound disclosed in Japanese Unexamined Patent Publication No. 29803/1983.

a - 1

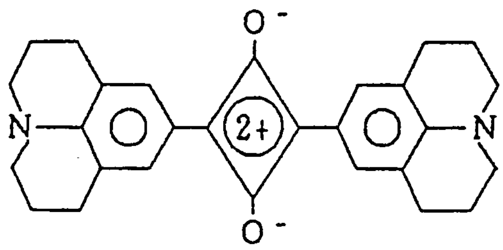

a - 2

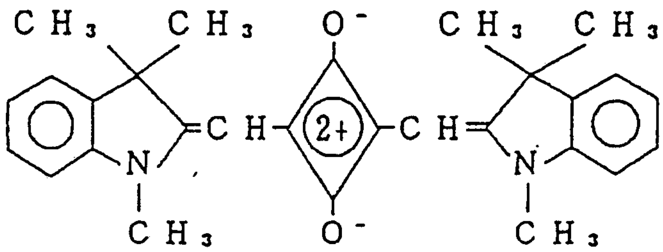

a - 3

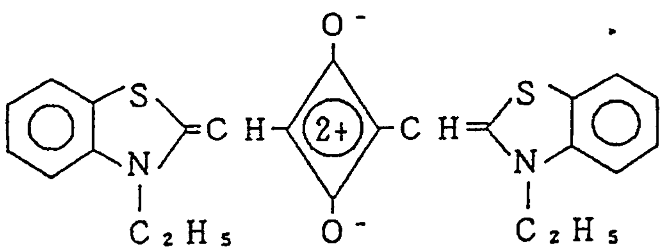

a - 4

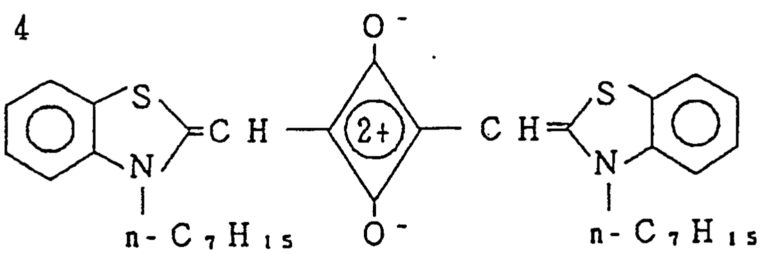

a - 5

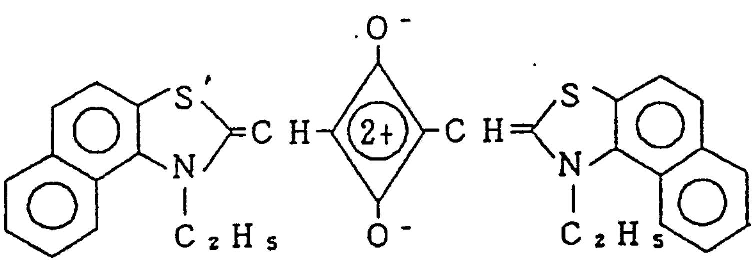

a - 6

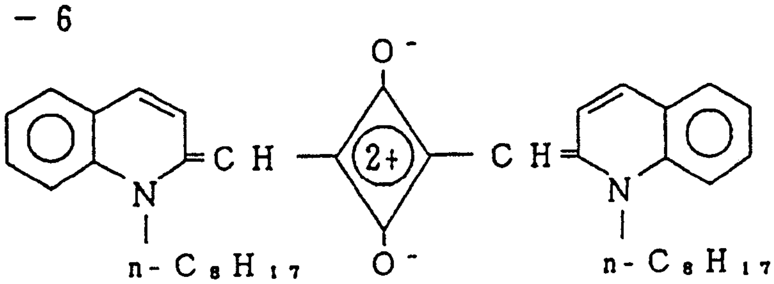

a - 7

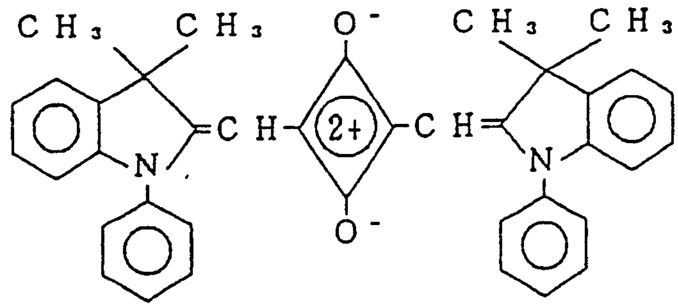

a - 8

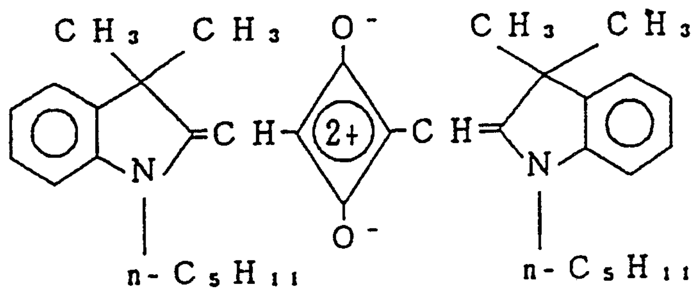

a - 9

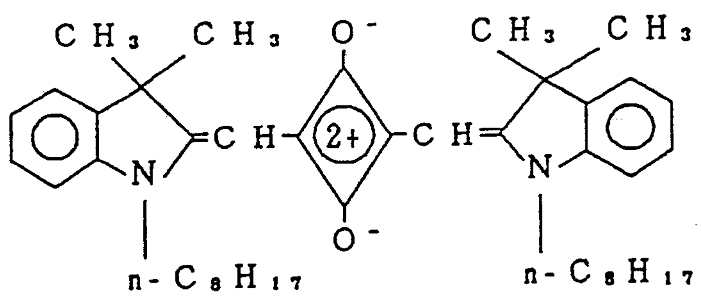

r - 1

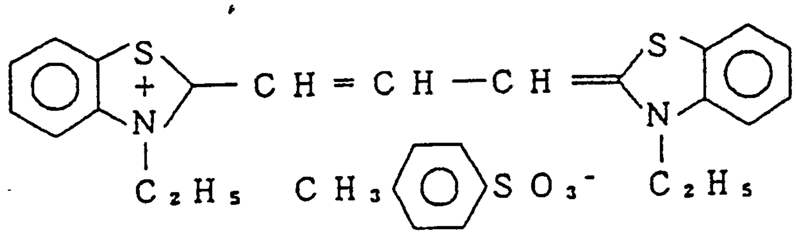

EXAMPLES 1 to 11 and COMPARATIVE EXAMPLES 1 to 3

Ten g of a methyl methacrylate/methacrylic acid copolymer (weight average molecular weight: 45,000, copolymerization ratio: 85/15), 10 g of trimethylolpropane triacrylate and 60 mg of methoxyphenol were dissolved in a solvent mixture comprising 550 g of chloroform and 50 g of methanol to obtain a photosensitive stock solution. This stock solution was divided, and to each divided solution, 1.5% by weight (based on solid content) of the component (a) and/or 4.0% by weight (based on solid content) of the s-triazine compound were added as identified in Table 1 to obtain a sample photosensitive solution. Each photosensitive solution was whirl coated on a grained and anodized aluminum sheet so that the dried film thickness would be 2.5 µm, followed by drying at 70°C for 3 minutes.

On its surface, an aqueous polyvinyl alcohol solution was coated to form an overcoat layer having a dried film thickness of 3 µm, whereby a photosensitive test sample was obtained. Then, such a test sample was exposed for a predetermined period of time by means of a spectral radiation apparatus (RM-23-I, manufactured by Narumi K.K.) and then developed by a developing solution (an aqueous solution containing 9% by weight of butyl cellosolve and 1% by weight of sodium silicate), whereby photocuring rates at various wavelength were obtained. In Table 1, the photocuring rate corresponding to the light rays having a wavelength of 650 nm is represented by a relative sensitivity based on the sensitivity of Example 3.

Table 1

| | Component (a) | s-Triazine | Relative sensitivity |
|---|---|---|---|
| Example 1 | a-1 | b-1 | 6.7 |
| Example 2 | a-2 | b-1 | 10.2 |
| Example 3 | a-3 | b-1 | 7.6 |
| Example 4 | a-4 | b-1 | 14.2 |
| Example 5 | a-5 | b-1 | 7.6 |
| Example 6 | a-6 | b-1 | 3.0 |
| Example 7 | a-2 | b-2 | 10.2 |
| Example 8 | a-2 | b-3 | 9.1 |
| Example 9 | a-2 | b-4 | 8.2 |
| Example 10 | a-2 | b-5 | 8.8 |
| Example 11 | a-2 | b-6 | 7.0 |
| Comparative Example 1 | a-2 | - | <0.1 |
| Comparative Example 2 | - | b-1 | <0.1 |
| Comparative Example 3 | r-1 | b-1 | 1.0 |

EXAMPLES 12 to 17

In these Examples, preparation of red-sensitive microcapsule photosensitive materials containing the composition of the present invention as an inner phase, will be described.

Firstly, 0.5 g of sodium salt of carboxymethylcellulose (manufactured by Daicel Chemical Industries, Ltd.) was dissolved in 10.0 mℓ of water. While stirring was continued by a stirrer provided with 6 vanes with a pitch of 45°, the following composition for the inner phase was added under a light-shielding condition at

room temperature.

| Red-sensitive microcapsule inner phase | |
|---|---|
| Pentaerythritol triacrylate | 3 g |
| Component (a) (squarylium dye) | Amount shown in Table 2 |
| s-Triazine | Amount shown in Table 2 |
| Cyan leuco dye Blue-220 manufactured by Yamada Kagaku K.K. | 180 mg |
| Toluene | 0.3 g |

After completion of the addition, the mixture was stirred and dispersed at 2,200 rpm for 40 minutes. Then, a prepolymer solution obtained by heat treating at 65° C for 30 minutes a mixture comprising 0.6 g of melamine, 1.0 g of formalin (37% concentration) and 8.3 g of water, was dropwise added thereto, and 0.6 g of ammonium sulfate was further added thereto. The mixture was stirred for further 2 hours at 70° C, then returned to room temperature and left to stand still. The supernatant was removed, and the corresponding amount of a 5% polyvinyl alcohol aqueous solution was added and mixed. The obtained capsule dispersion was coated on an art paper by a wire bar and dried in air and then at 80° C for 5 minutes to obtain a photosensitive sheet.

A developer sheet was prepared by coating a dispersion of a pressure sensitive reproduction developer RB (manufactured by Santo Kagaku K.K.) on an art paper sheet and dried in the same manner as in the case of the photosensitive sheet.

On the above photosensitive sheet, a black silver salt image film and a step tablet were disposed, and red light rays obtained by cutting light rays having wavelength of less than 600 nm from a xenone light source (UXL-1000D-0, manufactured by Ushio Denki K.K.) by a colored glass filter R-60 (manufactured by Toshiba Glass K.K.), were irradiated thereto for 5 seconds. Then, the photosensitive sheet was overlaid on the above-mentioned developer sheet, then passed through press rollers (250 kg/cm$^2$) and heated for 10 seconds in a 100° C over. In each Example presented in Table 2, a clear cyan-colored positive image was obtained on the developer sheet. Further, the relative sensitivity in the Table, was determined from the number of clear steps obtained through the step tablet, based on the sensitivity of Example 12.

Table 2

| | Component (a) [amount] | s-Triazine [amount] | Relative sensitivity |
|---|---|---|---|
| Example 12 | a-8 [15 mg] | b-1 [90 mg] | 1.0 |
| Example 13 | a-9 [15 mg] | b-1 [90 mg] | 1.0 |
| Example 14 | a-8 [7.5 mg]<br>a-9 [7.5 mg] | b-1 [150 mg] | 1.19 |
| Example 15 | a-8 [7.5 mg]<br>a-7 [7.5 mg] | b-1 [90 mg] | 1.0 |
| Example 16 | a-8 [3.8 mg]<br>a-7 [3.8 mg] | b-1 [90 mg] | 0.84 |
| Example 17 | a-8 [1.9 mg]<br>a-7 [1.9 mg] | b-1 [45 mg] | 0.59 |

EXAMPLE 18

In this Example, an example of full color copy will be shown.

For the light sensitive materials for the blue-sensitive microcapsules and the green-sensitive microcapsules, the initiator system comprising a cyanine dye and a s-triazine compound as disclosed in Japanese Unexamined Patent Publication No. 29803/1983, was used. The inner phase components of the above capsules, were as follows. Other conditions for the preparation of the microcapsules were the same as in Example 12.

| Blue-sensitive microcapsule inner phase | |
|---|---|
| Pentaerythritol triacrylate | 3 g |
| 3,3′-Diethyl-(6,7,6′,7′-dibenzo)-thiacyanine 2-naphthalenesulfonate | 3.8 mg |
| 3-n-Octyl-3′-methyl-(4,5-benzo)-thiacyanine p-tosylate | 3.8 mg |
| s-Triazine [b-1] | 90 mg |
| Yellow leuco dye Y-1 manufactured by Yamada Kagaku K.K. | 180 mg |
| Toluene | 0.3 g |

| Green-sensitive microcapsule inner phase | |
|---|---|
| Pentaerythritol triacrylate | 3 g |
| 3,3′-Di-n-heptyl-thiacarbocyanine-p-tosylate | 7.5 mg |
| 3,3′-Di-n-hexyl-thiacarbocyanine 2-naphthalinsulfonate | 7.5 mg |
| s-Triazine [b-1] | 90 mg |
| Mazenta leuco dye RED-40 manufactured by Yamamoto Kasei K.K. | 180 mg |
| Toluene | 0.3 g |

The above blue-sensitive and green-sensitive microcapsules and the same red-sensitive microcapsules as used in Example 16 were mixed in equal amounts, and a photosensitive sheet was prepared in the same manner as in Example 12. A color image masking film was overlaid thereon, and white light rays were irradiated for 2 seconds directly from the xenone light source as used in Example 12. This exposed sheet was treated in the same manner as in Example 12, whereupon a full color positive image which substantially accurately reproduced the color image of the masking film was obtained on the developer sheet.

## Claims

1. A photopolymerizable composition comprising an addition polymerizable ethylenically unsaturated compound and a photopolymerization initiator system, wherein the photopolymerization initiator system comprises:

   (a) a squarylium dye, and

   (b) a s-triazine compound having at least one halogenated methyl group.

2. The photopolymerizable composition according to Claim 1, wherein the ethylenically unsaturated compound is an ethylenically unsaturated carboxylic acid ester.

3. The photopolymerizable composition according to Claim 1 or 2, wherein the ethylenically unsaturated compound is a monomer of an acrylic acid ester or a methacrylic acid ester.

4. The photopolymerizable composition according to Claim 1, 2 or 3 wherein the squarylium dye has the formula:

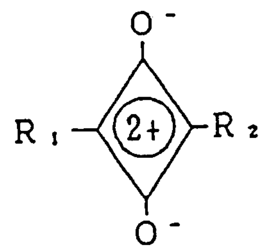

(I)

wherein each of $R_1$ and $R_2$ is a substituted or unsubstituted aminophenyl group or Y=CH- wherein Y= is a nitrogen-containing heterocyclic group.

5. The photopolymerizable composition according to Claim 4, wherein each of $R_1$ and $R_2$ is represented by the formula:

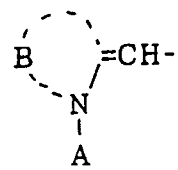

(II)

wherein A is an alkyl group or an aryl group, and B is a group of atoms necessary for forming a hetero ring.

6. The photopolymerizable composition according to Claim 4, wherein each of $R_1$ and $R_2$ is an (indolin-2-ylidene)methyl group, a (benzothiazolylidene)methyl group, a (naphtho[1,2-d]thiazol-2(3H)-ylidene)methyl group or a (2(1H)-quinolinylidene)methyl group.

7. The photopolymerizable composition according to any one of the preceding Claims, wherein the s-triazine compound is a s-triazine compound having at least two groups selected from the group consisting of a trichloromethyl group, a tribromomethyl group and a combination thereof.

8. The photopolymerizable composition according to Claim 7, wherein the s-triazine compound is 2,4,6-tris(trichloromethyl)-s-triazine, 2-phenyl-4,6-bis(trichloromethyl)-s-triazine, 2-methyl-4,6-bis(trichloromethyl)-s-triazine, 2-phenylthio-4,6-bis(trichloromethyl)-s-triazine or 2,4,6-tris(tribromomethyl)-s-triazine.

9. The photopolymerizable composition according to any one of the preceding Claims, wherein the weight ratio of the squarylium dye to the s-triazine compound is within a range of from 1:30 to 10:1.

10. The photopolymerizable composition according to any one of the preceding Claims, which contains an organic polymer material as a binder.

11. The photopolymerizable composition according to any one of the preceding Claims, which contains at least one member selected from the group consisting of a heat polymerization preventing agent, a coloring agent, a sensitivity-improving agent and a plasticizer.

12. The photopolymerizable composition according to any one of the preceding Claims, which contains a colorant precursor.